# EUROPEAN PATENT APPLICATION

(11) **EP 4 611 383 A1**
(43) Date of publication of application: **03.09.2025**
(21) Application number: 23894811.1
(22) Date of filing: 13.10.2023
(51) Int. Cl.: H04N 23/57, H04N 23/51, H04N 23/55, H05K 1/02, H05K 1/14

(54) **ELECTRONIC DEVICE COMPRISING CAMERA MODULE**

(30) Priority: 23.11.2022 KR 20220158786; 20.12.2022 KR 20220179857; 15.03.2023 KR 20230034217
(71) Applicant: Samsung Electronics Co., Ltd., Suwon-si, Gyeonggi-do 16677 (KR)
(72) Inventor: KIM, Dohoon, Suwon-si Gyeonggi-do 16677 (KR); SHIN, Sanggon, Suwon-si Gyeonggi-do 16677 (KR); FEYGENSON, Oleg, Suwon-si Gyeonggi-do 16677 (KR); KIM, Manho, Suwon-si Gyeonggi-do 16677 (KR); JO, Youngsun, Suwon-si Gyeonggi-do 16677 (KR)
(74) Representative: Gulde & Partner
(86) International application number: PCT/KR2023/015782
(87) International publication number: WO 2024/111882

(57) **Abstract**

An electronic device according to one embodiment comprises: a printed circuit board comprising a ground portion; a camera comprising a lens facing a first direction; a camera housing which comprises an opening in a first surface facing the first direction, and surrounds at least a portion of the camera; and a bracket electrically connected to the ground portion, and at least partially surrounding the camera housing. The camera housing comprises a bridge extending from the camera housing to a third surface of the bracket. Various other embodiments may be possible.

## Description

### [Technical Field]

The present disclosure relates to an electronic device including a camera module.

### [Background Art]

An electronic device may include a camera module for photographing a still image and/or a moving image. For example, the electronic device may include a front camera exposed to the front of the electronic device through an opening or a rear camera exposed through a rear cover. The electronic device may include a camera housing surrounding the camera. The camera housing may be grounded to shield electromagnetic waves emitted from the camera and electromagnetic waves reaching the camera housing from other electronic components.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device according to an embodiment may comprise a printed circuit board, a camera, a camera housing, and a bracket. The printed circuit board may include a ground portion. The camera may include a lens. The lens may face a first direction. The camera housing may include an opening. The opening may be formed for the lens exposed toward the outside within a first surface facing the first direction. The camera housing may surround at least a portion of the camera. The bracket may include a third surface. The third surface may face away from a second surface of the camera housing, which is perpendicular to the first surface. The bracket may be electrically connected to the ground portion. The bracket may at least partially surround the camera housing. The camera housing may include a bridge. The bridge may extend from the camera housing to the third surface of the bracket.

An electronic device according to an embodiment may comprise a printed circuit board, a camera, a camera housing, an injection portion, and a connecting member. The printed circuit board may include a ground portion. The camera may include a lens. The camera may be disposed on the printed circuit board. The camera housing may surround at least a portion of the camera. The injection portion may be disposed inside the camera housing. The injection portion may surround at least a portion of the camera. The connecting member may extend from a portion of an inner surface of the camera housing, which is exposed through a groove of the injection portion, to the ground portion.

### [Description of the Drawings]

FIG. 1 is a block diagram of an electronic device in a network environment according to an embodiment.
FIG. 2 is a block diagram illustrating a camera module according to an embodiment.
FIG. 3 is a perspective view of an exemplary electronic device.
FIG. 4 is a portion of an exploded perspective view of the electronic device of FIG. 3.
FIG. 5A illustrates an exemplary camera housing.
FIG. 5B illustrates a process of forming an exemplary camera housing.
FIG. 6 is a cross-sectional view of an exemplary electronic device cut along line A-A' of FIG. 3.
FIGS. 7A and 7B illustrate the camera housing illustrated in FIG. 6 being coupled to a bracket.
FIG. 8A is a cross-sectional view of an exemplary electronic device cut along line A-A' of FIG. 3.
FIGS. 8B and 8C illustrate the camera housing illustrated in FIG. 8A being coupled to a bracket.
FIG. 9 illustrates an exemplary camera housing.
FIGS. 10A and 10B are cross-sectional views of an exemplary electronic device including the camera housing of FIG. 9 cut along line A-A' of FIG. 3.
FIG. 11A schematically illustrates an exemplary camera housing being connected to a printed circuit board.
FIG. 11B schematically illustrates an exemplary camera housing being connected to a support.
FIG. 11C illustrates a process of forming an exemplary camera housing.
FIG. 12A illustrates the camera housing illustrated in FIG. 11A or 11B being coupled to a bracket in a first direction.
FIG. 12B illustrates the camera housing illustrated in FIG. 11A or 11B being coupled to a bracket in a direction opposite to the first direction.
FIG. 12C illustrates the camera housing illustrated in FIG. 10B being coupled to a bracket in a direction opposite to the first direction.
FIG. 13A is an exploded perspective view of an exemplary camera and camera housing.
FIG. 13B illustrates an injection portion of an exemplary camera housing.
FIG. 14A is a cross-sectional view of an exemplary electronic device cut along line A-A' of FIG. 3.
FIG. 14B is an enlarged view of a portion X of FIG. 14A.

### [Mode for Invention]

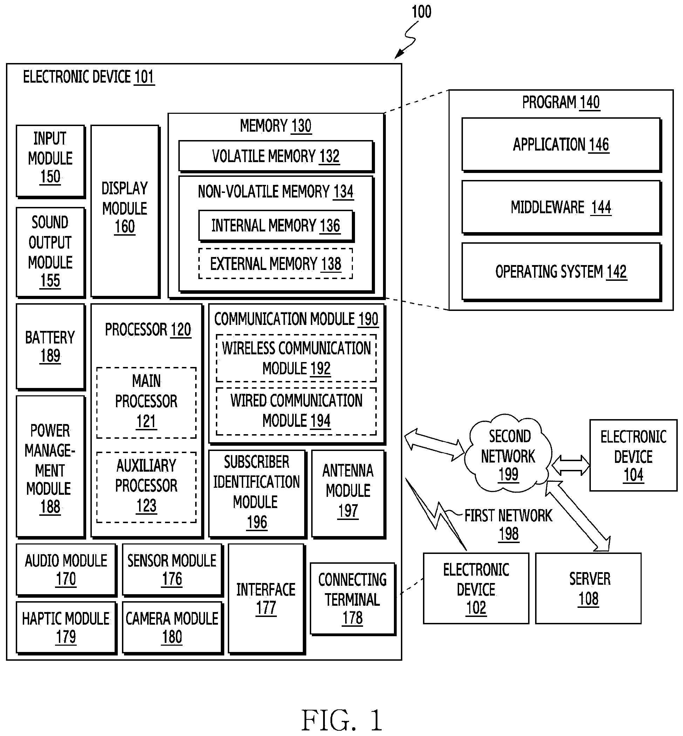

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

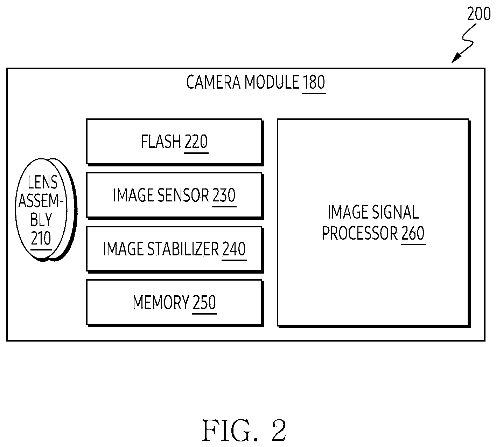

FIG. 2 is a block diagram 200 illustrating the camera module 180 according to various embodiments.

Referring to FIG. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules180 may form a rear camera.

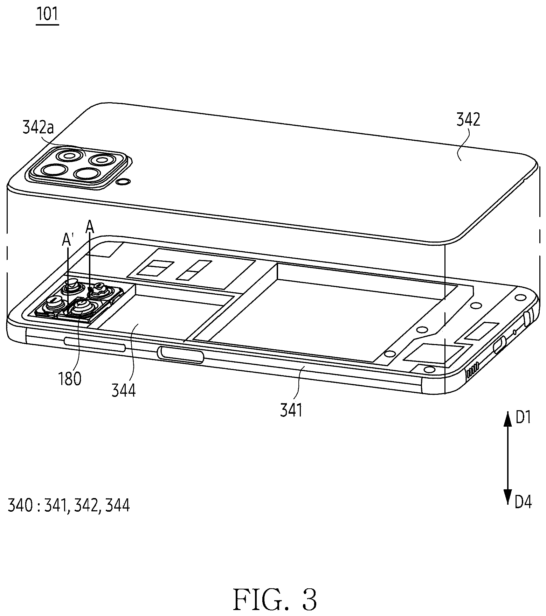

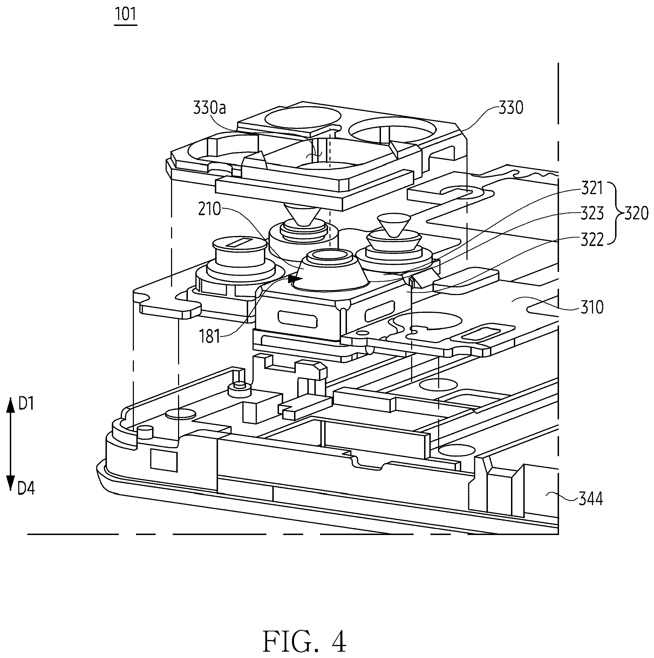

FIG. 3 is a perspective view of an exemplary electronic device 101. FIG. 4 is a portion of an exploded perspective view of the electronic device 101 of FIG. 3.

Referring to FIGS. 3 and 4, the electronic device 101 according to an embodiment may include a housing 340, a printed circuit board 310, a camera module (e.g., the camera module 180 of FIG. 2), a camera housing 320, and a bracket 330. For example, the electronic device 101 may be a mobile terminal including a front camera and/or a rear camera, but is not limited thereto. The electronic device 101 may include one or more camera modules. According to an embodiment, the camera module 180 may include a camera 181 including a lens 210.

According to an embodiment, the housing 340 may form an exterior surface of the electronic device 101. For example, the housing 340 may include a support 344 configured to support components of the electronic device 101, a first plate 341 surrounding the support 344 and/or a second plate 342 coupled to the first plate 341 and disposed on the support 344. For example, the first plate 341 may be referred to as a side member forming side surfaces of the electronic device 101. For example, the support 344 may be referred to as a supporting portion extending from the first plate 341 toward an inside of the housing 340. For example, the first plate 341 and the support 344 may be integrated, but are not limited thereto. The camera module 180 and/or the printed circuit board 310 may be disposed on the support 344. The second plate 342 may face a first direction D1. The second plate 342 may include a camera decoration 342a for covering the camera module 180. Although not illustrated, the housing 340 may further include a third plate facing the second plate 342. For example, the third plate may face a fourth direction D4 opposite to the first direction D1.

According to an embodiment, the printed circuit board 310 may be disposed on a surface of the support 344 facing the first direction D1. For example, the printed circuit board 310 and the camera 181 may be disposed side by side on the support 344. For example, the printed circuit board 310 and the camera 181 may be electrically connected through electrical wires. The printed circuit board 310 may include a plurality of conductive layers and a plurality of non-conductive layers alternately laminated with the plurality of conductive layers. For example, the printed circuit board 310 may include a ground portion for grounding electronic components. The printed circuit board 310 may provide an electrical connection between various electronic components of the electronic device 101, by using wires and conductive vias formed on the conductive layer. For example, the camera 181 may be electrically connected to a processor (e.g., the processor 120 of FIG. 1) through the printed circuit board 310.

According to an embodiment, the camera 181 may be disposed on the support 344. The camera 181 may include a lens 210 facing the first direction D1. FIG. 3 illustrates that the camera 181 faces the second plate 342 of the electronic device 101, but it is not limited thereto. For example, the first direction D1 may be a direction in which the second plate 342 faces or an opposite direction to a direction in which the second plate 342 faces. The camera 181 may include one or more lenses. For example, the lens 210 may collect light emitted from a subject that is a target of an image capture. For example, the lens 210 may include a wide-angle lens or a telephoto lens, but is not limited thereto. According to an embodiment, the electronic device 101 may include a plurality of cameras disposed at different positions. Although not illustrated, the camera 181 may further include an actuator for driving the lens 210 and/or an image sensor (e.g., the image sensor 230 of FIG. 2).

According to an embodiment, the camera housing 320 may surround at least a portion of the camera 181. For example, the camera housing 320 may be referred to as a shield can. Referring to FIG. 4, the camera housing 320 may include a first surface 321 facing the first direction D1 and a second surface 322 substantially perpendicular to the first surface 321. The camera 181 may be disposed within a space surrounded by the first surface 321 and the second surface 322. The camera housing 320 may include an opening 323 for a lens 210 exposed toward an outside of the camera housing 320 within the first surface 321. A portion of the lens 210 may pass through the opening 323. For example, the lens 210 may be exposed from an inside of the camera housing 320 through the opening 323 to an outside of the first surface 321 of the camera housing 320 facing the first direction D1. The lens 210 may be configured to collect light emitted from a subject by being exposed to the outside of the camera housing 320 through the opening 323. According to an embodiment, the camera housing 320 may protect the camera 181 accommodated therein. The camera housing 320 may shield electromagnetic waves emitted from other electronic components (e.g., an antenna module) of the electronic device 101 from reaching the camera 181. The camera housing 320 may be configured to shield electromagnetic waves emitted from the camera 181.

According to an embodiment, the bracket 330 may at least partially surround the camera housing 320. The bracket 330 may be fixed to the support 344 and/or the printed circuit board 310 to fix a position of the camera 181 at a designated position within the housing 340. For example, the bracket 330 may include an accommodating space 330a for surrounding at least a portion of the camera 181. The camera housing 320 may be disposed within the accommodating space 330a.

As various electronic components (e.g., speaker, microphone, or antenna) are disposed in the electronic device 101, electromagnetic compatibility (EMC) of the camera 181 may be required. For example, in the housing 340, an antenna module (e.g., the antenna module 197 of FIG. 1) may be adjacent to the camera 181. When a transmission signal transmitted from an antenna module to an external electronic device is coupled to the camera 181 adjacent to the antenna module, malfunction of some components (e.g., image sensor and/or actuator) of the camera 181 may occur. For example, when electromagnetic waves emitted during operations of some components (e.g., image sensor and/or actuator) of the camera 181 is induced to an antenna module adjacent to the camera 181, performance (e.g., sensitivity) of the antenna module may be degraded. According to an embodiment, the camera housing 320 surrounding at least a portion of the camera 181 may be required to be electrically grounded to shield electromagnetic waves emitted from the camera 181 and shield electromagnetic waves emitted from other electronic components from reaching the camera 181. Enhancing the grounding performance of the camera housing 320 may improve electromagnetic interference (EMI) and/or electromagnetic susceptibility (EMS). When the camera housing 320 is directly connected to a ground portion of the printed circuit board 310, a separate connecting member (e.g., c-clip or conductive tape) may be required for an electrical connection between the camera housing 320 and the ground portion. For example, when the camera housing 320 is electrically connected to the ground portion through the separate connecting member, an internal short may occur due to separation of the connecting member.

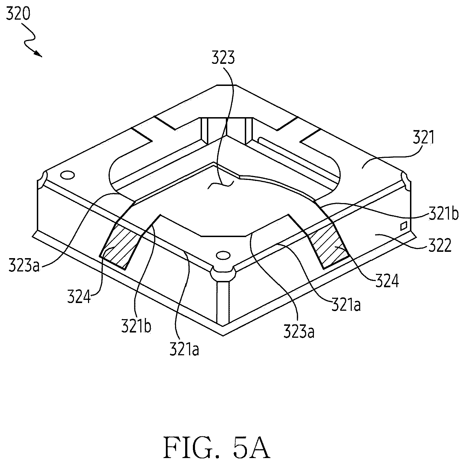

According to an embodiment, the camera housing 320 surrounding at least a portion of the camera 181 may be grounded for EMC of the camera 181 via the bracket 330. For example, the bracket 330 may be connected to a ground portion of the printed circuit board 310 and/or a ground region of the support 344. The camera housing 320 at least partially surrounded by the bracket 330 may be connected to the bracket 330. According to an embodiment, the camera housing 320 may include a bridge (e.g., the bridge 324 of FIG. 5A) for being connected to the bracket 330. The bridge 324 may be implemented as a portion of the camera housing 320, rather than as a separate connecting member independent of the camera housing 320. The camera housing 320 electrically connected to the ground region may shield electromagnetic waves reaching the camera 181 from other electronic components, and/or electromagnetic waves emitted from the camera 181. As the camera housing 320 is grounded, electromagnetic interference between the camera 181 and other electronic components (e.g., speaker, microphone, or antenna) within the electronic device 101 may be reduced. According to an embodiment, the electronic device 101 may reduce malfunctions and/or degradation of signal quality due to noise, by reducing electromagnetic interference.

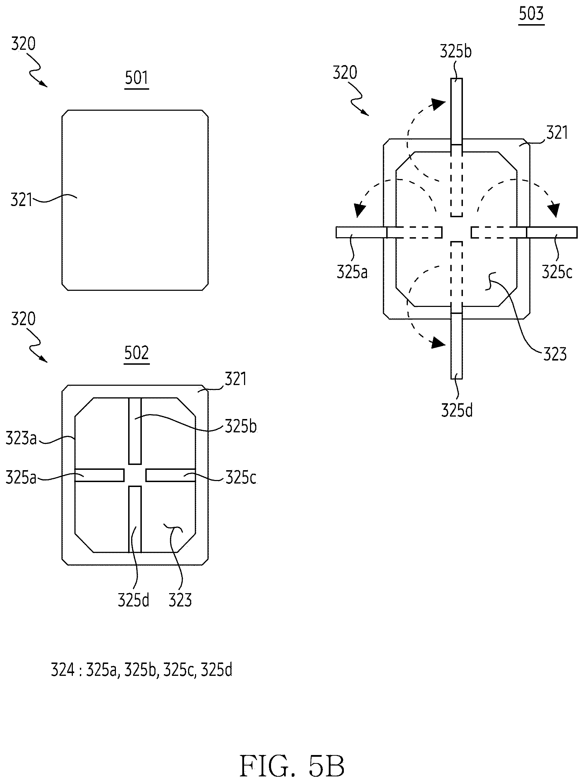

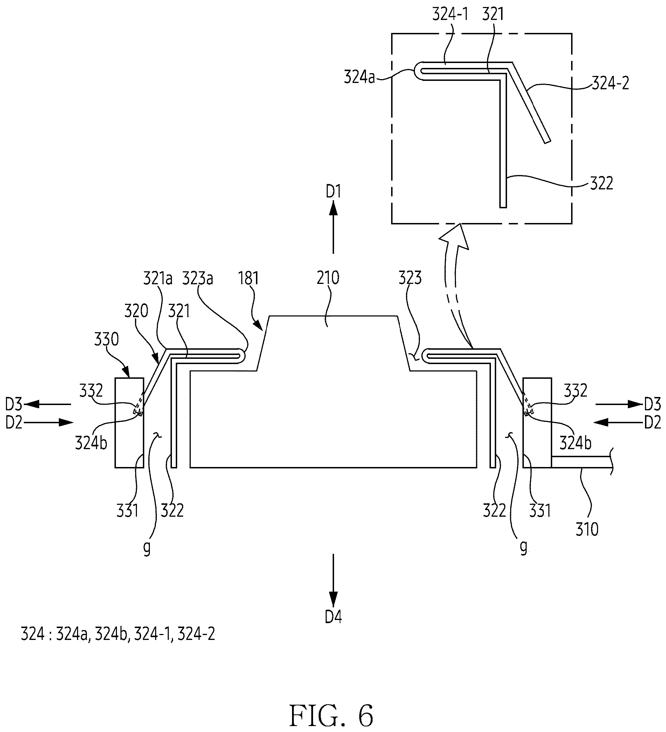

FIG. 5A illustrates an exemplary camera housing 320. FIG. 5B illustrates a process of forming an exemplary camera housing 320. FIG. 6 is a cross-sectional view of an exemplary electronic device 101 cut along line A-A' of FIG. 3.

Referring to FIG. 5A, the camera housing 320 may include a first surface 321 and a second surface 322 substantially perpendicular to the first surface 321. The second surface 322 may extend substantially perpendicularly with respect to the first surface 321 from a periphery 321a of the first surface 321. An opening 323 may be formed in the first surface 321. A camera (e.g., the camera 181 of FIG. 4) may be disposed within a space surrounded by the first surface 321 and the second surface 322. The space surrounded by the first surface 321 and the second surface 322 may be exposed to the outside of the camera housing 320 through the opening 323. At least a portion of a lens (e.g., the lens 210 of FIG. 4) of the camera 181 may be exposed to the outside of the camera housing 320 through the opening 323.

According to an embodiment, the camera housing 320 may include at least one bridge 324. Referring to FIG. 5B, the bridge 324 may be formed during a process of forming the opening 323 of the first surface 321. States 501, 502, and 503 of FIG. 5B schematically illustrate the first surface 321 of the camera housing 320 in the process of forming the camera housing 320 including the bridge 324.

For example, the state 501 indicates a top view of the camera housing 320 before the opening 323 is formed. Before the opening 323 is formed, the first surface 321 may close the internal space.

The state 502 indicates a top view of the camera housing 320 in a state that an opening 323 is formed by processing a portion of the first surface 321. For example, the opening 323 may be formed by a press method of punching a portion of the first surface 321, but is not limited thereto. In the process of forming the opening 323, the bridge 324 extending from a portion of a periphery 323a of the opening 323 within the first surface 321 toward a center of the opening 323 may be formed. For example, the opening 323 may be formed by leaving the bridge 324 in the first surface 321 and removing a remaining portion.

According to an embodiment, the bridge 324 may be one or more. For example, the camera housing 320 may include a plurality of bridges 325a, 325b, 325c, and325d formed along the periphery 323a of the opening 323. The plurality of bridges 325a, 325b, 325c, and 325d may be symmetrical to each other. For example, the camera housing 320 may include four bridges 325a, 325b, 325c, and 325d that are symmetrical to each other with respect to the center of the opening 323. For example, the four bridges 325a, 325b, 325c, and 325d may be disposed to be orthogonal to each other at 90 degrees. For example, a first bridge 325a and a third bridge 325c may face each other. For example, a second bridge 325b and a fourth bridge 325d may face each other. However, it is not limited thereto. When the plurality of bridges 325a, 325b, 325c, and 325d are disposed symmetrically, the area for grounding the camera housing 320 may increase, so the grounding effect of the camera housing 320 may be improved.

The state 503 indicates a top view of the camera housing 320 in a state that the bridge 324 is folded toward the outside of the camera housing 320. In the state 502, the bridge 324 may extend from the periphery 323a of the opening 323 toward the center of the opening 323. A portion of the bridge 324 may be folded toward the outside of the camera housing 320 so that the bridge 324 is contacted with a bracket (e.g., the bracket 330 of FIG. 6) at least partially surrounding the camera housing 320. The folded portion of the bridge 324 may be referred to as a bending portion (e.g., the bending portion 324a of FIG. 6).

According to an embodiment, the bridge 324, which was extended toward the center of the opening 323, may be folded to face the outside of the camera housing 320. The bridge 324 may be extended toward the bracket 330 through the bending portion 324a and may be contacted with the bracket 330. The camera housing 320 may be electrically connected to a ground portion that is electrically connected to the bracket 330, through the bridge 324 contacted with the bracket 330.

Referring to FIG. 6, the bracket 330 may include a third surface 331 faced away from the second surface 322. The third surface 331 being faced away from the second surface 322 may refer to a structure in which a direction in which the third surface 331 faces is opposite to a direction in which the second surface 322 faces, and the third surface 331 is spaced apart from the second surface 322. The bracket 330 may be electrically connected to a ground portion of the printed circuit board 310. The bridge 324 may be folded from a portion of the periphery 323a of the opening 323 formed in the first surface 321 toward the periphery 321a of the first surface 321, thereby contacting with the third surface 331.

According to an embodiment, the bridge 324 may extend from a portion of the periphery 323a of the opening 323 to the third surface 331 faced away from the second surface 322. The third surface 331 may be referred to as an inner surface of the bracket 330 facing the camera housing 320. For example, a gap g may be formed between the second surface 322 of the camera housing 320 and the third surface 331 of the bracket 330. The bridge 324 may extend to the third surface 331 through the gap g between the second surface 322 and the third surface 331. As the bridge 324 is contacted with the third surface 331 of the bracket 330, the camera housing 320 and the bracket 330 may be electrically connected. Since the bracket 330 is electrically connected to the ground portion of the printed circuit board 310, the camera housing 320 may be electrically connected to the ground portion of the printed circuit board 310 through the bracket 330 contacted with the bridge 324.

According to an embodiment, the bridge 324 may include a bending portion 324a. The bending portion 324a may be formed at an end portion of the bridge 324. The end potion of the bridge 324 may be referred to as a portion that contacts a portion of the periphery 323a of the opening 323. If the bending portion 324a protrudes toward the opening 323 when folded, it may affect the lens 210 passing through the opening 323. In order to prevent the bending portion 324a from interfering with the lens 210, the first surface 321 of the camera housing 320 may include a cut portion (e.g., the cut portion 321b of FIG. 5A) cut out from a portion of the periphery 323a of the opening 323, in which the bridge 324 extends, toward the periphery 321a of the first surface 321. For example, the cut portion 321b may extend from a portion of the periphery 323a of the opening 323 toward the periphery 321a of the first surface 321 with a width corresponding to a width of the bridge 324. A length of the cut portion 321b may be less than or equal to a length between the periphery 323a of the opening 323 and the periphery 321a of the first surface 321. When the bending portion 324a is folded, the cut portion 321b may form the bending portion 324a, so the bending portion 324a may be disposed on the outside of the opening 323. According to an embodiment, since the bending portion 324a is disposed on the outside of the opening 323, interference between the bending portion 324a and the lens 210 may be reduced.

According to an embodiment, the bending portion 324a may be bent from a portion of the periphery 323a of the opening 323 in a third direction D3 that is opposite to a second direction D2 toward the lens 210 passing through the opening 323. The bridge 324 may extend toward the bracket 330 disposed on the outside of the camera housing 320, through the bending portion 324a. According to an embodiment, the bridge 324 may include the bending portion 324a, a first portion 324-1, and a second portion 324-2. The first portion 324-1 may extend from the bending portion 324a in the third direction D3. The second portion 324-2 may extend from the first portion 324-1 with an inclination with respect to the first portion 324-1. For example, the second portion 324-2 may extend in a direction between the third direction D3 and a fourth direction D4 opposite to the first direction D1. For example, the second portion 324-2 may extend to a gap g between the second surface 322 and the third surface 331 and may contact the third surface 331. The camera housing 320 may be electrically connected to a ground portion, via the bridge 324 contacted with the third surface 331 of the bracket 330 electrically connected to the ground portion. The camera housing 320 electrically connected to the ground portion may be configured to shield electromagnetic waves reaching the camera 181 from other electronic components, and/or electromagnetic waves emitted from the camera 181.

According to an embodiment, the bridge 324 may be disposed between the camera housing 320 and the bracket 330 to fix the camera housing 320 within the bracket 330. For example, the bridge 324 may have elasticity. For example, the camera housing 320 may include an elastic material (e.g., stainless steel). The bridge 324 extending from the camera housing 320 may include the same material as the camera housing 320. For example, the bridge 324 may have a width capable of providing elasticity. The camera housing 320 within the bracket 330 may be coupled to the bracket 330 by the elasticity of the bridge 324. When the camera housing 320 is coupled into the bracket 330, the bridge 324 may be compressed to be less than or equal to a gap g between the bracket 330 and the camera housing 320. After the camera housing 320 is inserted within the bracket 330, the camera housing 320 may be supported by the restoring force of the bridge 324. The bridge 324 may be configured to support the camera housing 320 with respect to the bracket 330.

According to an embodiment, since the camera housing 320 may be coupled to the bracket 330 by utilizing the elasticity of the bridge 324, the stress applied to the camera housing 320 may be reduced. For example, when the camera housing 320 is inserted into the bracket 330 through at least one protrusion formed on a side surface of the camera housing 320 (e.g., force-fitting), the camera 181 within the camera housing 320 may continuously receive stress applied from the protrusion. Since the camera 181 has at least one circuit that is vulnerable to damage, it may be damaged by continuously applied stress. In order to protect the camera 181 having a sensitive circuit, the bridge 324 may be configured to reduce the stress due to coupling by supporting the camera housing 320 using elasticity. According to an embodiment, since the bridge 324 extends from the first surface 321 of the camera housing 320, the stress due to the elastic force of the bridge 324 may be transferred to the first surface 321 of the camera housing 320. Since the stress due to the elastic force of the bridge 324 may be transferred to the first surface 321 when the bridge 324 supports the camera housing 320 with respect to the bracket 330, the stress applied to the camera 181 disposed inside the camera housing 320 may be reduced.

According to an embodiment, the bracket 330 may include a groove 332 formed within the third surface 331. The bridge 324 may include an inserting portion 324b inserted within the groove 332. For example, the groove 332 may be recessed into the interior of the bracket 330 from the third surface 331. A shape of the inserting portion 324b may correspond to a shape of the groove 332. When the camera housing 320 is coupled into the bracket 330, a position of the inserting portion 324b may correspond to a position of the groove 332. The camera housing 320 may be fixed within the bracket 330 through the inserting portion 324b inserted within the groove 332. The inserting portion 324b may prevent the camera housing 320 from being separated from the bracket 330. The contact area of the bridge 324 and the bracket 330 may be increased through the inserting portion 324b and the groove 332 that are contacted with each other. As the contact area of the bridge 324 and the bracket 330 is increased, an electrical connection between the camera housing 320 and the bracket 330 may be improved, so the grounding effect of the camera housing 320 may be improved.

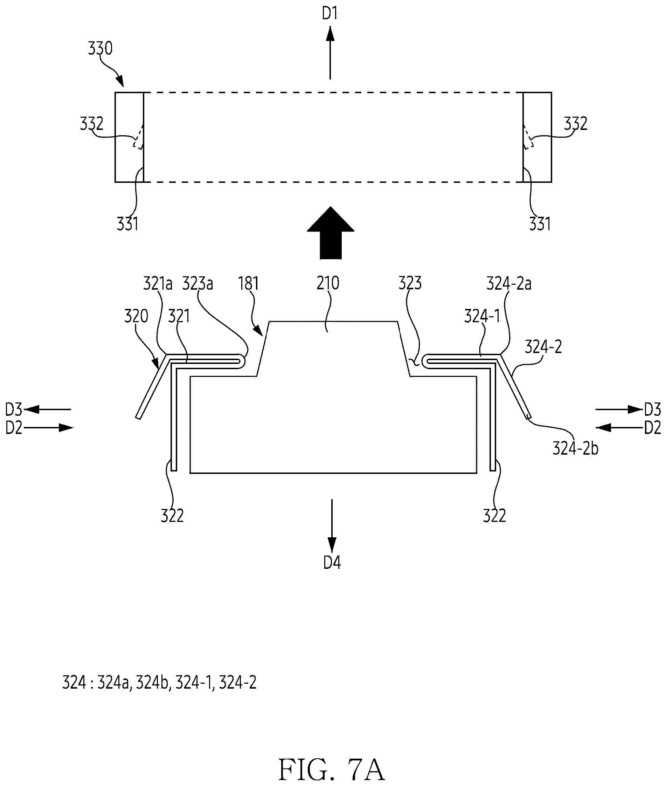

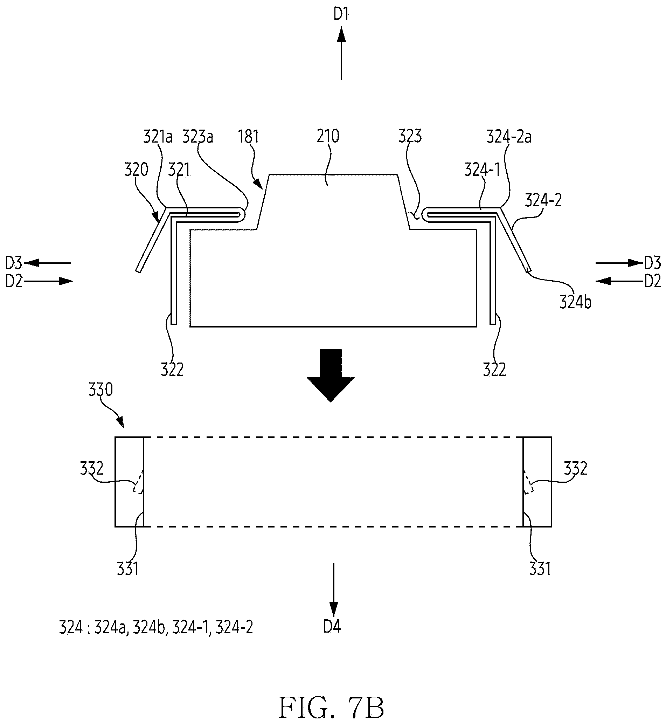

FIGS. 7A and 7B illustrate the camera housing 320 illustrated in FIG. 6 being coupled to a bracket 330.

According to an embodiment, the shape of the bridge 324 may be different according to a coupling direction of the camera housing 320 and the bracket 330.

Referring to FIG. 7A, the camera housing 320 including the bridge 324 including the first portion 324-1 and the second portion 324-2 described above may be coupled to the bracket 330 in the first direction D1. In the gap g between the second surface 322 and the third surface 331, the second portion 324-2 may extend in a direction between the third direction D3 and the fourth direction D4. Since the second portion 324-2 has an incline with respect to the first portion 324-1, when an end 324-2a of the second portion 324-2 connected to the first portion 324-1 is inserted into the bracket 330 before another end 324-2b of the second portion 324-2, the camera housing 320 may be naturally coupled into the bracket 330. After the end 324-2a of the second portion 324-2 is first inserted into the bracket 330, when the camera housing 320 is pushed into the bracket 330 in the first direction D1, the second portion 324-2 may be naturally compressed and inserted into the bracket 330. The other end 324-2b of the second portion 324-2 may be contacted with the third surface 331 of the bracket 330. When the groove 332 is formed in the bracket 330, at least a portion of the second portion 324-2 may be inserted into the groove 332. After the second portion 324-2 is fully inserted into the bracket 330, the camera housing 320 may be supported relative to the bracket 330 by the elastic force of the bridge 324. The camera housing 320 of the above structure may be naturally inserted into the bracket 330 when it is coupled into the bracket 330 in the first direction D1.

Referring to FIG. 7B, when the camera housing 320 including the bridge 324 including the first portion 324-1 and the second portion 324-2 is coupled to the bracket 330 in the fourth direction D4, the other end 324-2b of the second portion 324-2 may be inserted into the bracket 330 before the end 324-2a of the second portion 324-2. In order to form the elastic force of the bridge 324 inside the bracket 330, the position of the bridge 324 may be designed to be tightly coupled to the internal space of the bracket 330. When the other end 324-2b of the second portion 324-2 is inserted into the bracket 330 before the first end 324-2a of the second portion 324-2, the other end 324-2b may be positioned on the outside of the opening 323 (e.g., in the third direction D3). When the camera housing 320 of the above structure is coupled in the fourth direction D4, the bridge 324 may be damaged by being caught on the opening 323, or insertion of the camera housing 320 may be difficult.

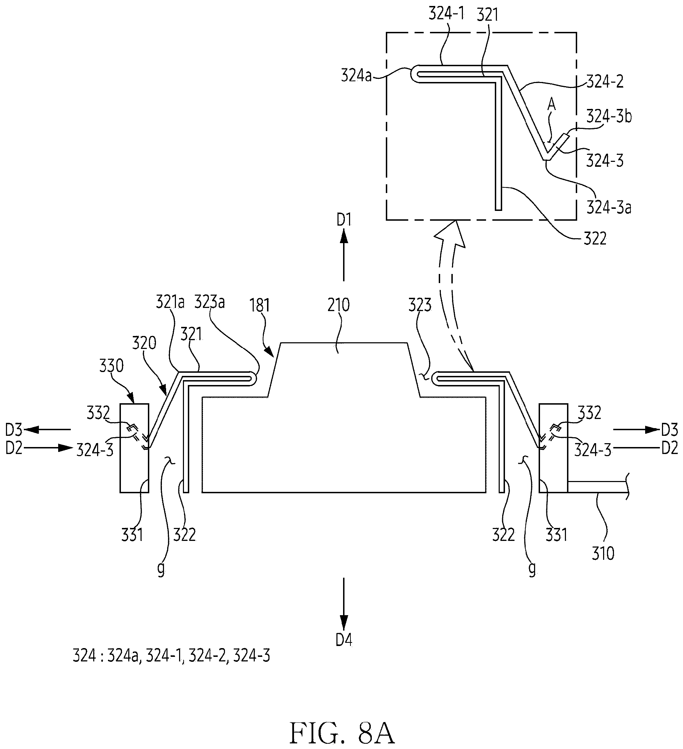

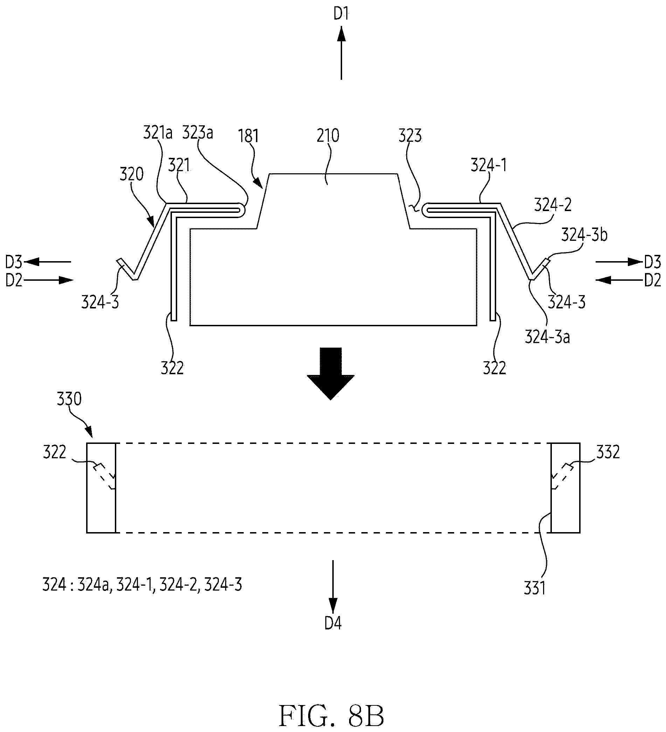

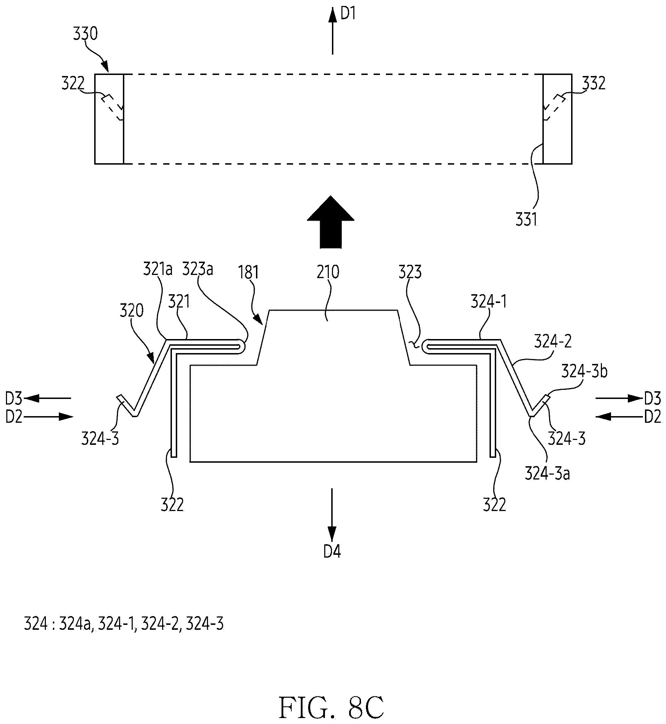

FIG. 8A is a cross-sectional view of an exemplary electronic device 101 cut along line A-A' of FIG. 3. FIGS. 8B and 8C illustrate the camera housing 320 illustrated in FIG. 8A being coupled to a bracket 330.

Referring to FIG. 8A, the bridge 324 may include a bending portion 324a, a first portion 324-1, a second portion 324-2, and a third portion 324-3. A structure of the bridge 324 illustrated in FIG. 8A may be a structure suitable for the camera housing 320 to be coupled to the bracket 330 in the fourth direction D4.

According to an embodiment, the second portion 324-2 may extend from the first portion 324-1 to a point between the second surface 322 and the third surface 331. The second portion 324-2 may extend to a gap g between the second surface 322 and the third surface 331 without contacting the third surface 331 of the bracket 330. The third portion 324-3 may extend from the second portion 324-2 in a direction between the first direction D1 and the third direction D3, and may contact the third surface 331. For example, the third portion 324-3 may extend from an end 324-3a connected to the second portion 324-2 to another end 324-3b. The third portion 324-3 may contact the third surface 331 of the bracket 330, or, when a groove 332 is formed in the bracket 330, at least a portion of the third portion 324-3 may be inserted into the groove 332 of the bracket 330. An angle between the second portion 324-2 and the third portion 324-3 may be an acute angle (e.g., the angle A of FIG. 8A). Since the third portion 324-3 is bent relative to the second portion 324-2, the bridge 324 may include a bending portion between the bent portion 324a and the second portion 324-2 and the third portion 324-3.

Referring to FIG. 8B, the camera housing 320 including the bridge 324 including the bending portion 324a, the first portion 324-1, the second portion 324-2, and the third portion 324-3 may be coupled to the bracket 330 in the fourth direction D4. Since the third portion 324-3 extends in a direction between the first direction D1 and the third direction D3, when the end 324-3a of the third portion 324-3 connected to the second portion 324-2 is inserted into the bracket 330 before the other end 324-3b of the third portion 324-3, the camera housing 320 may be naturally coupled into the bracket 330. For example, before the camera housing 320 is coupled into the bracket 330, the end 324-3a of the third portion 324-3 may be positioned inward of the third surface 331 of the bracket 330 (e.g., in the second direction D2). When the end 324-3a of the third portion 324-3 is first inserted into the bracket 330 and then the camera housing 320 is pushed into the bracket 330 in the fourth direction D4, the second portion 324-2 and the third portion 324-3 may be naturally compressed and inserted into the bracket 330. For example, the other end 324-3b of the third portion 324-3 may be contacted with the third surface 331 of the bracket 330. When a groove 332 is formed in the bracket 330, at least a portion of the third portion 324-3 may be inserted into the groove 332. After the second portion 324-2 and the third portion 324-3 are fully inserted into the bracket 330, the camera housing 320 may be supported by the bracket 330 by the elastic force of the bridge 324. The camera housing 320 of the above structure may be naturally inserted into the bracket 330 when it is coupled into the bracket 330 in the fourth direction D4.

Referring to FIG. 8C, when the camera housing 320 including the bridge 324 including the bending portion 324a, the first portion 324-1, the second portion 324-2, and the third portion 324-3 is coupled to the bracket 330 in the first direction D1, the other end 324-3b of the third portion 324-3 protruding toward the outside of the camera housing 320 may be positioned on the outside of the third surface 331 of the bracket 330 (e.g., the third direction D3). When the camera housing 320 is pressed in the first direction D1 in a state that a portion of the third portion 324-3 is positioned on the outside of the third surface 331, the bridge 324 may be damaged by being caught on the opening 323, or insertion of the camera housing 320 may be difficult.

According to an embodiment, a shape of the bridge 324 may vary according to a coupling direction of the camera housing 320 and the bracket 330. For example, when the camera housing 320 is required to be coupled to the bracket 330 in the first direction D1, the bridge 324 may include the first portion 324-1 and the second portion 324-2. For example, when the camera housing 320 is required to be coupled to the bracket 330 in the fourth direction D4, the bridge 324 may include the first portion 324-1, the second portion 324-2, and the third portion 324-3. According to an embodiment, the camera housing 320 is not limited to a specific coupling direction and may have a bridge 324 with a suitable structure according to the coupling direction.

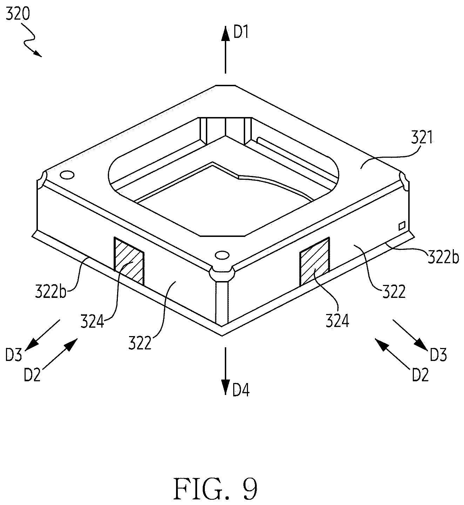

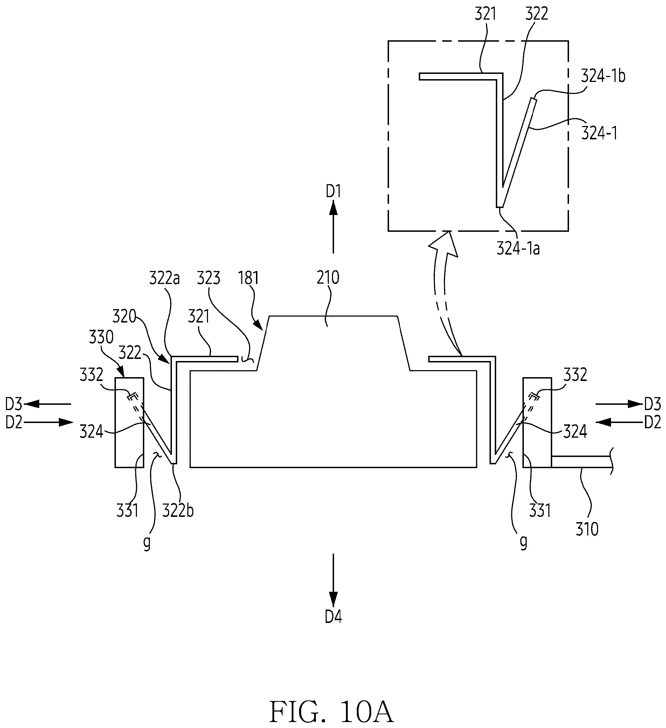

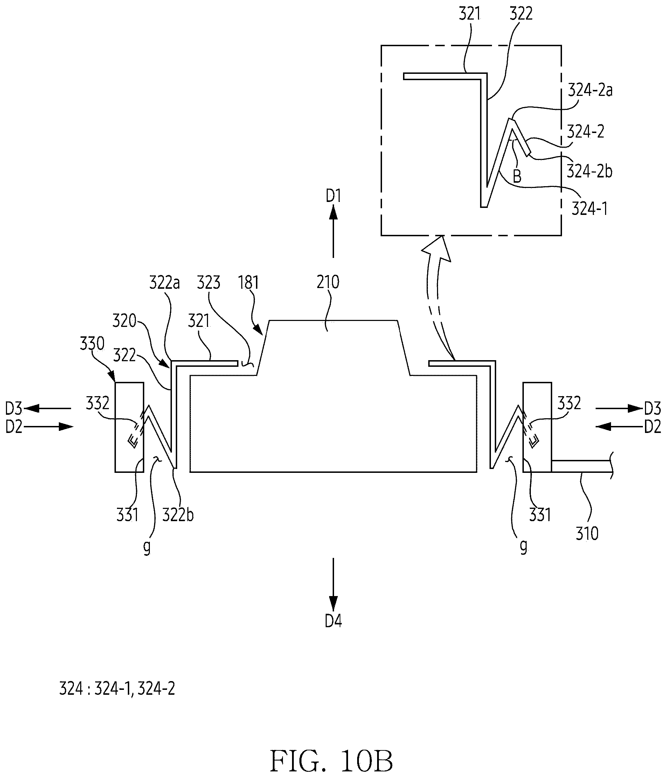

FIG. 9 illustrates an exemplary camera housing 320. FIGS. 10A and 10B are cross-sectional views of an exemplary electronic device 101 including the camera housing 320 of FIG. 9 cut along line A-A' of FIG. 3.

Referring to FIGS. 9, 10A, and 10B, the bridge 324 may extend from the second surface 322 of the camera housing 320. For example, the second surface 322 may extend substantially perpendicularly to the first surface 321. A direction in which the second surface 322 extends may be a fourth direction D4 opposite to a first direction D1 in which the first surface 321 faces. The bridge 324 may extend from a portion of the other end 322b of the second surface 322 opposite to the end 322a of the second surface 322 connected to the first surface 321, in a direction between the first direction D1 and the third direction D3. The other end 322b may be referred to as an end of the fourth direction D4 of the second surface 322.

According to an embodiment, the bridge 324 may extend from a portion of the other end 322b of the second surface 322 to the third surface 331 of the bracket 330. The bridge 324 may connect the camera housing 320 and the bracket 330. The camera housing 320 may be electrically connected to a ground portion of the printed circuit board 310 through the bracket 330. The bridge 324 formed on the portion of the other end 322b of the second surface 322 may support the camera housing 320 relative to the bracket 330 in the gap g between the second surface 322 and the third surface 331. When the camera housing 320 is inserted into the bracket 330, the bridge 324 having elasticity may be inserted in a compressed state. In the bracket 330, the bridge 324 may be coupled, by restoring force, between the third surface 331 of the bracket 330 and the second surface 322 of the camera housing 320.

According to an embodiment, the force by which the bridge 324 supports the camera housing 320 may be provided to an end of the camera housing 320. For example, the stress applied to the camera housing 320 by the elastic force of the bridge 324 may be transferred to the other end 322b of the second surface 322 of the camera housing 320. When the bridge 324 supports the camera housing 320 relative to the bracket 330, the stress due to the elastic force of the bridge 324 may be transferred to the other end 322b of the second surface 322, so the stress applied to the camera 181 disposed inside the camera housing 320 may be reduced. According to an embodiment, since at least one circuit inside the camera 181 may receive less stress due to the elastic force of the bridge 324, damage to the at least one circuit may be reduced.

According to an embodiment, a shape of the bridge 324 may vary according to a coupling direction of the camera housing 320 and the bracket 330. Referring to FIG. 10A, the bridge 324 may include the first portion 324-1. The first portion 324-1 may extend from a portion of the other end 322b of the second surface 322 in a direction between the first direction D1 and the third direction D3. The first portion 324-1 may extend to the gap g between the second surface 322 and the third surface 331 and may contact the third surface 331. When a groove 332 is formed in the bracket 330, at least a portion of the first portion 324-1 may be inserted into the groove 332.

The camera housing 320 of the structure illustrated in FIG. 10A may be coupled to the bracket 330 in the fourth direction D4. When the camera housing 320 is coupled to the bracket 330 in the fourth direction D4, an end portion 324-1a of the first portion 324-1 connected to the second surface 322 may be inserted into the bracket 330 earlier than another end portion 324-1b of the first portion 324-1 opposite to the end portion 324-1a. Since the other end portion 324-1b is positioned further outward from the camera housing 320 than the end portion 324-1a, when the camera housing 320 is inserted into the bracket 330 in the fourth direction D4, the first portion 324-1 may be naturally compressed toward the camera housing 320 by the bracket 330. For example, the other end portion 324-1b may be inserted into the groove 332 of the bracket 330. In a state that the camera housing 320 is fully inserted into the bracket 330, the bridge 324 may support the camera housing 320 relative to the bracket 330.

Referring to FIG. 10B, the bridge 324 may include a first portion 324-1 and a second portion 324-2. The first portion 324-1 may extend from a portion of the other end portion 322b of the second surface 322 in a direction between the first direction D1 and the third direction D3. The second portion 324-2 may extend from the first portion 324-1 in a direction between the third direction D3 and the fourth direction D4 and may contact the third surface 331. When the groove 332 is formed in the bracket 330, at least a portion of the second portion 324-2 may be inserted into the groove 332. An angle between the first portion 324-1 and the second portion 324-2 may be an acute angle (e.g., the angle B of FIG. 10B). Since the second portion 324-2 is bent relative to the first portion 324-1, the bridge 324 may include a bent portion between the first portion 324-1 and the second portion 324-2.

The camera housing 320 of the structure illustrated in FIG. 10b may be coupled to the bracket 330 in the first direction D1. When the camera housing 320 is coupled to the bracket 330 in the first direction D1, an end portion 324-2a of the second portion 324-2 connected to the first portion 324-1 may be inserted into the bracket 330 earlier than another end portion 324-2b of the second portion 324-2 spaced from the first portion 324-1. Since the other end portion 324-2b is positioned further outward from the camera housing 320 than the end portion 324-2a, when the camera housing 320 is inserted into the bracket 330 in the first direction D1, the bridge 324 may be naturally compressed toward the camera housing 320 by the bracket 330. For example, the other end portion 324-2b may be inserted into the groove 332 of the bracket 330. In a state that the camera housing 320 is fully inserted into the bracket 330, the bridge 324 may support the camera housing 320 relative to the bracket 330.

According to an embodiment, the camera housing 320 having the bridge 324 extending from a portion of the other end portion 322b of the second surface 322 may be electrically connected to a ground portion of a printed circuit board 310 through the bracket 330. The camera housing 320 electrically connected to the ground portion may shield electromagnetic waves reaching the camera 181 from other electronic components and/or electromagnetic waves emitted from the camera 181 within the camera housing 320. Through the bridge 324, the camera housing 320 may be fixed within the bracket 330. Since the bridge 324 is formed on a portion of the other end portion 322b of the second surface 322, the stress applied to the camera housing 320 may not be transferred to the camera 181 but may be transferred to the other end portion 322b of the second surface 322. According to an embodiment, damage to the camera 181 due to the stress may be reduced. According to an embodiment, a shape of the bridge 324 may be different according to a coupling direction of the camera 181.

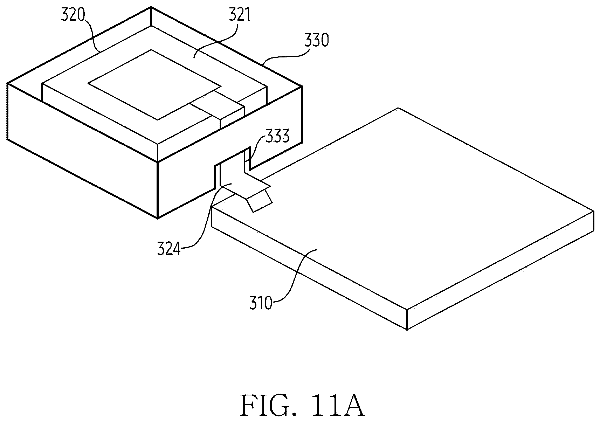

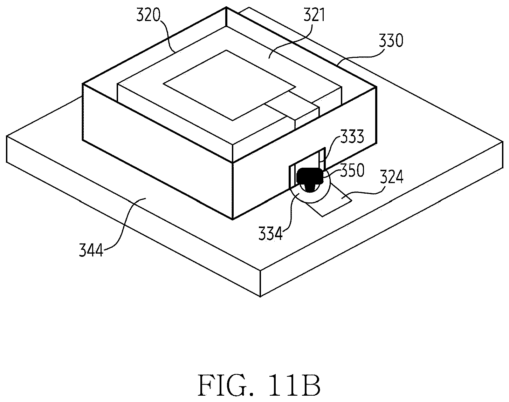

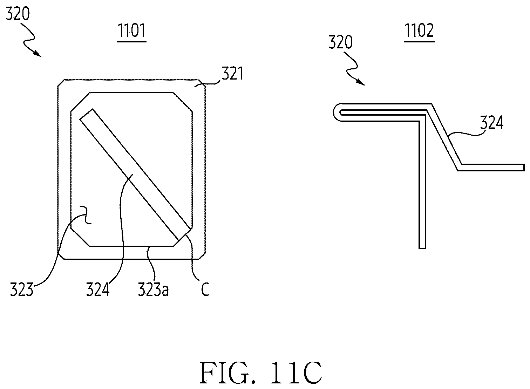

FIG. 11A schematically illustrates an exemplary camera housing 320 being connected to a printed circuit board 310. FIG. 11B schematically illustrates an exemplary camera housing 320 being connected to a support 344. FIG. 11C illustrates a process of forming an exemplary camera housing 320.

Referring to FIG. 11A, the camera housing 320, which is disposed within the bracket 330, may be directly connected to the printed circuit board 310. According to one embodiment, the bridge 324 may pass through the bracket 330 and extend to a ground portion of the printed circuit board 310. When the bridge 324 is connected to the ground portion, the camera housing 320 may be electrically connected to the ground portion through the bridge 324.

According to an embodiment, the bracket 330 may include a through hole 333. The through hole 333 may be formed on a side surface of the bracket 330. For example, the through hole 333 may be formed on a side surface of the bracket 330 adjacent to the printed circuit board 310. The bridge 324 extending from the first surface 321 of the camera housing 320 may pass through the through hole 333. For example, the bridge 324 may have a length that passes between the camera housing 320 and the bracket 330 and extends through the through-hole 333. The bridge 324 exposed through the through hole 333 may be connected to the ground portion of the printed circuit board 310. For example, the bridge 324 may be connected to the ground portion through a conductive connecting member (e.g., c-clip) for electrical connection. Since the bridge 324 is connected to the ground portion, the camera housing 320 may be directly grounded, without passing through the bracket 330. The grounded camera housing 320 may shield electromagnetic waves reaching the camera 181 from other electronic components and/or electromagnetic waves emitted from the camera 181 disposed inside the camera housing 320.

Referring to FIG. 11B, the camera housing 320 disposed within the bracket 330 may be directly connected to a ground region of the support 344. According to an embodiment, the bridge 324 may extend through the bracket 330 to the ground region of the support 344. When the bridge 324 is connected to the ground region, the camera housing 320 may be electrically connected to the ground portion through the bridge 324.

According to an embodiment, the bracket 330 may include a through hole 333. The through hole 333 may be formed on a side surface of the bracket 330. For example, the through hole 333 may be formed on a side surface of the bracket 330 adjacent to the ground region of the support 344. The bridge 324 extending from the first surface 321 of the camera housing 320 may pass through the through hole 333. For example, the bridge 324 may have a length that passes between the camera housing 320 and the bracket 330 and extends through the through hole 333. The bridge 324 exposed through the through hole 333 may be connected to the ground region of the support 344.

According to an embodiment, the bracket 330 may include a protruding portion 334 into which a screw 350 is inserted. For example, the protruding portion 334 may be contacted with the through hole 333. The screw 350 may penetrate the bridge 324 and the protruding portion 334, and may be inserted into the grounding region. Since the screw 350 penetrates the bridge 324 and the protruding portion 334, the camera housing 320 may be electrically connected to the grounding region. For example, the screw 350 may include a conductive material (e.g., metal), and the bridge 324 may be electrically connected to the ground region through the screw 350. Since the bridge 324 is connected to the ground region through the screw 350, the camera housing 320 may be directly grounded without passing through the bracket 330. The grounded camera housing 320 may shield electromagnetic waves reaching the camera 181 from other electronic components and/or electromagnetic waves emitted from a camera (e.g., the camera 181 of FIG. 6) disposed inside the camera housing 320. The screw 350 may fix the bracket 330 to the support 344. Since the screw 350 may penetrate the protruding portion 334 and be inserted into the support 344, the bracket 330 may be fixed at a designated position on the support 344.

According to an embodiment, in order for the bridge 324 to pass through the bracket 330 and be connected to the printed circuit board 310 and/or the support 344, it may be required to secure a length of the bridge 324. Since the length of the bridge 324 may be limited by the opening 323, in order to secure the length of the bridge 324, the bridge 324 may be formed to have the longest length within the opening 323.

1101 of FIG. 11C illustrates a first surface 321 when the camera housing 320 is viewed from above. 1102 of FIG. 11C illustrates a side surface of the camera housing 320. Referring to 1101 of FIG. 11C, the bridge 324 may extend from a portion of the periphery 323a of the opening 323 toward a center of the opening 323. In order for the bridge 324 to be formed to be the longest in the opening 323, the bridge 324 may be formed between two points that are farthest apart from each other in the periphery 323a of the opening 323. For example, a portion of the periphery within the first surface 321 where the bridge 324 is formed may be positioned at a corner C of the opening 323. For example, the bridge 324 may be formed between two points diagonally crossing the opening 323, but is not limited thereto. Referring to 1102 of FIG. 11C, the length of the bridge 324 may be formed relatively long. The elongated bridge 324 may have a length that may pass through a through-hole (e.g., the through-hole 333 of FIG. 11A) of a bracket (e.g., the bracket 330 of FIG. 11A) and extend to the printed circuit board 310 and/or the support 344. According to an embodiment, when the camera housing 320 is directly connected to the printed circuit board 310 and/or the support 344, the grounding effect of the camera housing 320 may be enhanced. Since the camera housing 320 may shield electromagnetic waves emitted from the camera 181, the influence of the camera 181 on other electronic components may be reduced. Since the camera housing 320 may shield electromagnetic waves reaching the camera 181 from other electronic components, malfunctions of the camera 181 may be reduced.

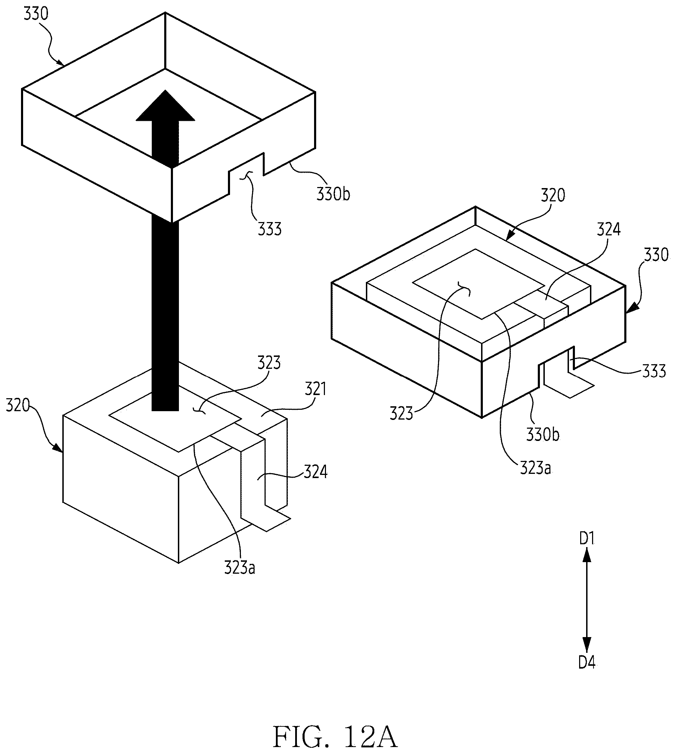

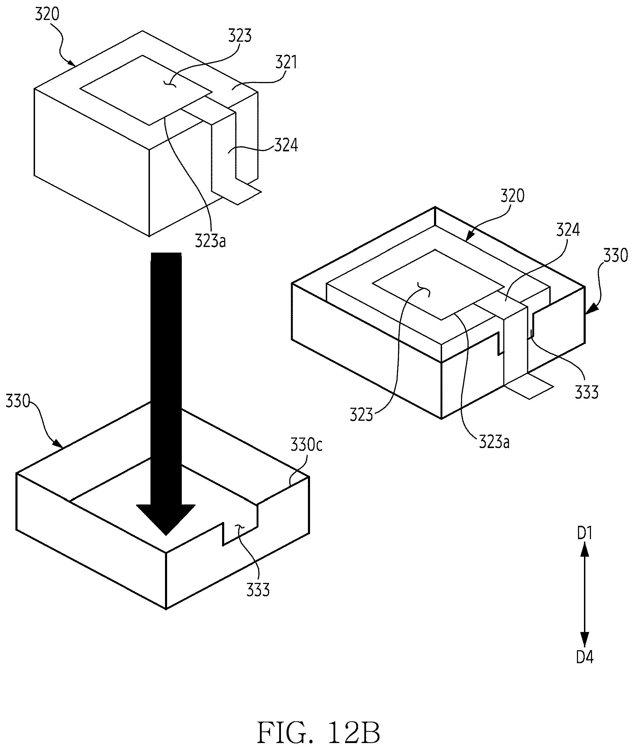

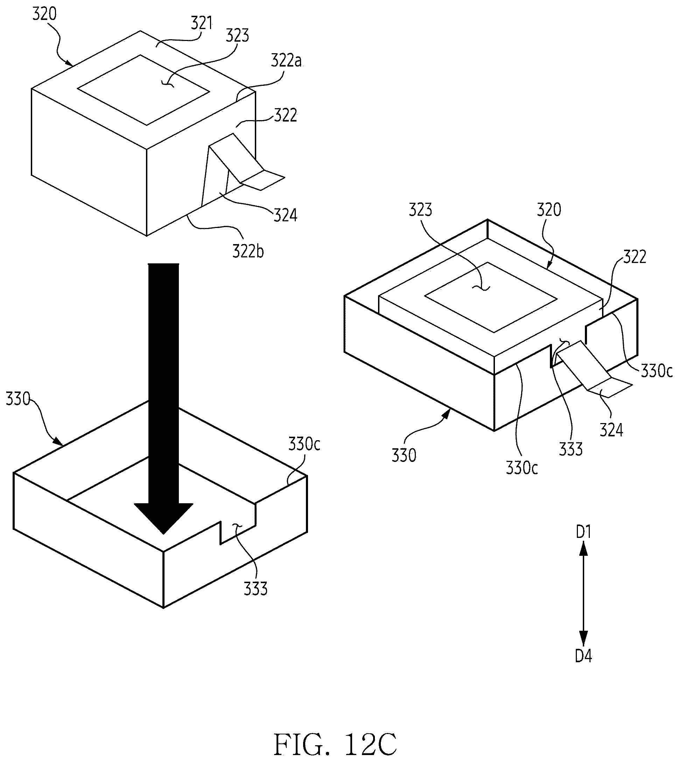

FIG. 12A illustrates the camera housing 320 illustrated in FIG. 11A or 11B being coupled to a bracket 330 in a first direction D1. FIG. 12B illustrates the camera housing 320 illustrated in FIG. 11A or 11B being coupled to a bracket 330 in a direction opposite to the first direction D1. FIG. 12C illustrates the camera housing 320 illustrated in FIG. 10B being coupled to a bracket 330 in a fourth direction D4 opposite to the first direction D1.

According to an embodiment, a position of the through hole 333 of the bracket 330 may be different based on a direction in which the camera housing 320 is coupled to the bracket 330 or a position in which the bridge 324 is formed.

Referring to FIG. 12A, the camera housing 320 may be inserted into the bracket 330 in the first direction D1. The bridge 324 may extend from a portion of the periphery 323a of the opening 323. When the camera housing 320 is coupled to the bracket 330 in the first direction D1, the through hole 333 may be formed at a corner 330b in a direction opposite to the direction in which the camera housing 320 is inserted within the side surface of the bracket 330, in order to correspond to the bridge 324 extending from a portion of the periphery 323a of the opening 323. For example, the through hole 333 may be formed along a portion of the corner 330b in the fourth direction D4, which is opposite to the first direction D1, within the side surface of the bracket 330. For example, the through hole 333 may extend from a portion of the corner 330b of the fourth direction D4 within the side surface of the bracket 330 to the first direction D1. The bridge 324 may be exposed to the outside of the bracket 330, through the through hole 333. The bridge 324 passing the through hole 333 may be electrically connected to a printed circuit board (e.g., the printed circuit board 310 of FIG. 4) and/or a support (e.g., the support 344 of FIG. 4). When the camera housing 320 includes a plurality of bridges 324, the bracket 330 may include a plurality of through holes 333 corresponding to each of the plurality of bridges 324. The plurality of through holes 333 may be formed along a portion of the corner 330b of the fourth direction D4 within the side surface of the bracket 330, respectively.

Referring to FIG. 12B, the camera housing 320 may be inserted into the bracket 330 in the fourth direction D4. The bridge 324 may extend from a portion of the periphery 323a of the opening 323. When the camera housing 320 is coupled to the bracket 330 in the fourth direction D4, the through hole 333 may be formed in the corner 330c in a direction opposite to the direction in which the camera housing 320 is inserted within the side surface of the bracket 330, in order to correspond to the bridge 324 extending from a portion of the periphery 323a of the opening 323. For example, the through hole 333 may be formed along a portion of the corner 330c in the first direction D1, which is opposite to the fourth direction D4, within the side surface of the bracket 330. For example, the through hole 333 may extend from a portion of the corner 330c in the first direction D1 within the side surface of the bracket 330, toward the fourth direction D4. The bridge 324 may be exposed to the outside of the bracket 330, through the through hole 333. The bridge 324 passing the through hole 333 may be electrically connected to the printed circuit board 310 and/or the support 344. When the camera housing 320 includes a plurality of bridges 324, the bracket 330 may include a plurality of through holes 333 corresponding to each of the plurality of bridges 324. The plurality of through holes 333 may be formed along a portion of the corner 330c of the first direction D1 within the side surface of the bracket 330, respectively.

Referring to FIG. 12C, the camera housing 320 may be inserted into the bracket 330 in the fourth direction D4. The bridge 324 may be extended from the second surface 322 of the camera housing 320. For example, the bridge 324 may be extended from a portion of the other end portion 322b of the second surface 322 opposite to the end portion 322a of the second surface 322 connected to the first surface 321. When the camera housing 320 is coupled to the bracket 330 in the fourth direction D4, the through hole 333 may be formed in the corner 330c in a direction opposite to the direction in which the camera housing 320 is inserted within the side surface of the bracket 330, in order to correspond to the bridge 324 extending from a portion of the other end portion 322b of the second surface 322. For example, the through hole 333 may be formed along a portion of the corner 330c in the first direction D1, which is opposite to the fourth direction D4, within the side surface of the bracket 330. For example, the through hole 333 may extend from a portion of the corner 330c in the first direction D1 within the side surface of the bracket 330, toward the fourth direction D4. The bridge 324 may be exposed to the outside of the bracket 330, through the through hole 333. The bridge 324 passing the through hole 333 may be electrically connected to a printed circuit board (e.g., the printed circuit board 310 of FIG. 4) and/or a support (e.g., the support 344 of FIG. 4). When the camera housing 320 includes a plurality of bridges 324, the bracket 330 may include a plurality of through holes 333 corresponding to each of the plurality of bridges 324. The plurality of through holes 333 may be formed along a portion of the corner 330c of the first direction D1 within the side surface of the bracket 330, respectively. According to an embodiment, when the bridge 324 passes through the through hole 333 and is connected to the printed circuit board 310 and/or the support 344, a position of the through hole 333 may be determined based on a coupling direction of the camera housing 320 relative to the bracket 330 and/or a position of the bridge 324. FIGS. 12A, 12B, and 12C are only exemplary, and various other embodiments may be possible.

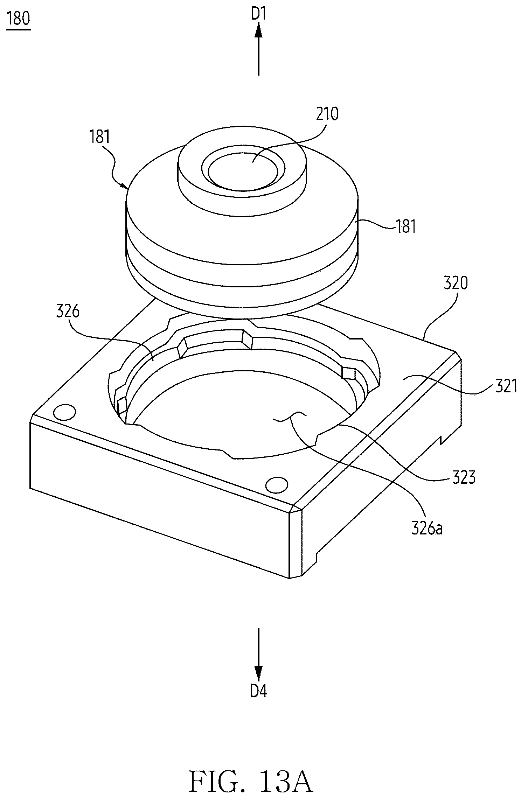

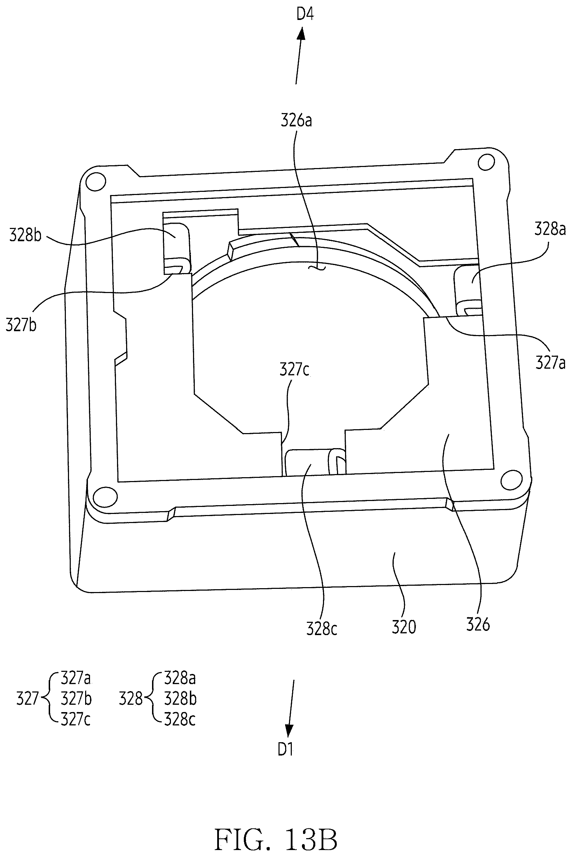

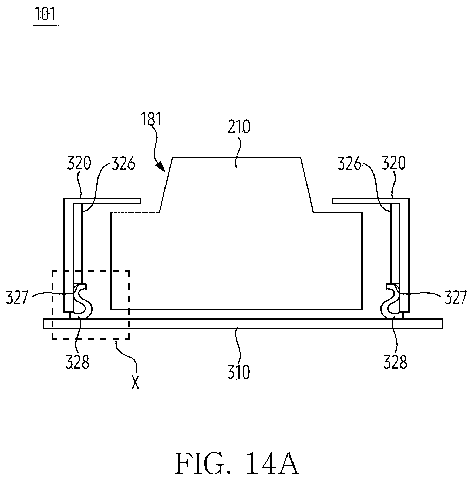

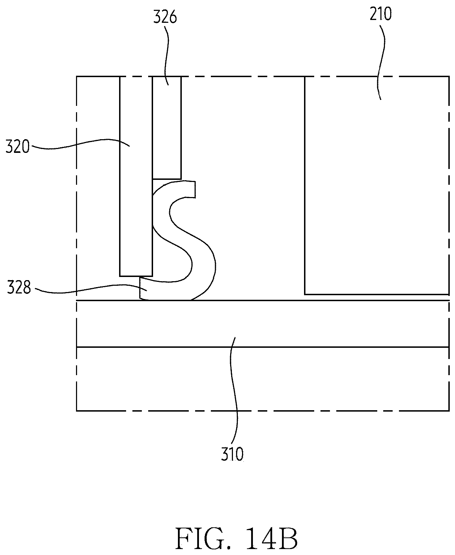

FIG. 13A is an exploded perspective view of an exemplary camera 181 and camera housing 320. FIG. 13B illustrates an injection portion 326 of an exemplary camera housing 320. FIG. 14A is a cross-sectional view of an exemplary electronic device 101cut along line A-A' of FIG. 3. FIG. 14B is an enlarged view of a portion X of FIG. 14A.

Referring to FIGS. 13A and 13B, the camera housing 320 may include an injection portion 326 and a connecting member 328. For example, the injection portion 326 may be disposed inside the camera housing 320. For example, the injection portion 326 may be contacted with an inner surface of the camera housing 320. The injection portion 326 may be configured to support one or more components of the camera module 180 inside the camera housing 320. For example, the injection portion 326 may at least partially surround the inner surface of the camera housing 320. For example, the injection portion 326 may support a lens 210 positioned inside the camera housing 320 and/or an actuator (not illustrated) for driving the lens 210, and may protect the lens 210 and/or the actuator. For example, the injection portion 326 may include a non-conductive material (e.g., polymer).

According to an embodiment, the camera housing 320 at least partially surrounding the camera 181 and the injection portion 326 may include an opening for the camera 181. For example, referring to FIG. 13A, a first opening 323 for the lens 210 exposed to the outside of the camera housing 320 may be formed in the first surface 321 of the camera housing 320. For example, referring to FIG. 13B, the injection portion 326 may include a second opening 326a for electrical connection between the camera 181 and a printed circuit board (e.g., the printed circuit board 310 of FIG. 14A). The second opening 326a may be formed on a surface (e.g., bottom surface) of the injection portion 326 opposite the first surface 321. For example, the first surface 321 may be a surface facing the first direction D1. For example, the injection portion 326 may form at least a portion of a surface facing the fourth direction D4.

According to an embodiment, the connecting member 328 may electrically connect the camera housing 320 to a ground portion of a printed circuit board 310 (e.g., printed circuit board 310 of FIG. 14A). The camera housing 320 may be grounded via the connecting member 328. Referring to FIG. 13B, the connecting member 328 may be positioned within a groove 327 of the injection portion 326. For example, the groove 327 may be formed by cutting a portion of the injection portion 326 from a periphery of the second opening 326a toward an inner surface of the camera housing 320.

For example, the groove 327 may include a plurality of grooves 327a, 327b, and 327c that are spaced apart from each other. As illustrated in FIG. 13B, the groove 327 may include a first groove 327a, a second groove 327b, and/or a third groove 327c that are spaced apart from each other, but it is not limited thereto. Since the injection portion 326 contacts the inner surface of the camera housing 320, the inner surface of the camera housing 320 contacted with the injection portion 326 may not be exposed by the injection portion 326. Since the groove 327 is formed by cutting a portion of the injection portion 326, a portion of the inner surface of the camera housing 320 may be exposed through the groove 327.

For example, the connecting member 328 may be positioned within the groove 327. The connecting member 328 may include a plurality of connecting members 328 that contact a plurality of portions of the inner surface of the camera housing 320 exposed through the plurality of grooves 327a, 327b, and 327c. For example, the connecting member 328 may include a first connecting member 328a positioned within the first groove 327a, a second connecting member 328b positioned within the second groove 327b, and/or a third connecting member 328c positioned within the third groove 327c, but it is not limited thereto. For example, positions and numbers of the grooves 327 and the connecting members 328 may vary according to the size of the camera module 180 and the design of the electronic device 101.

Referring to FIG. 14A, the camera housing 320 may be electrically connected to the ground portion of the printed circuit board 310 through the connecting member 328. For example, the camera 181 and the camera housing 320 may be disposed on the printed circuit board 310. For example, the connecting member 328 may extend from the inner surface of the camera housing 320 exposed through the groove 327 to the ground portion of the printed circuit board 310. Although not illustrated, the ground portion may include a ground layer of the printed circuit board 310. Since the groove 327 is formed by cutting a portion of the injection portion 326, a portion of the inner surface of the camera housing 320 corresponding to the groove 327 may not be covered by the injection portion 326. The camera housing 320 may be electrically connected to the ground portion through the connecting member 328 that contacts the inner surface of the camera housing 320 exposed through the groove 327 and the ground portion of the printed circuit board 310. The connecting member 328 may include a conductive material (e.g., metal) to electrically connect the camera housing 320 and the ground portion. For example, the connecting member 328 may be implemented as a portion of a c-clip, but is not limited thereto.

Referring to FIG. 14B, the connecting member 328 that contacts the inner surface of the camera housing 320 and the ground portion of the printed circuit board 310, may not be exposed to the outside of the camera housing 320. For example, the connecting member 328 may be overlapped with the camera housing 320 by extending from a portion the inner surface of the camera housing 320 exposed through the groove 327 within the camera housing 320. The connecting member 328 being overlapped with the camera housing 320 may indicate that the connecting member 328 is positioned entirely inside the camera housing 320, without a portion positioned outside the camera housing 320. For example, a shape of the connecting member 328 may be a shape having an approximately semicircular cross-section, unlike a shape of a typical c-clip having an approximately circular cross-section, but it is not limited thereto. For example, the connecting member 328 may have a partially bent shape.

According to an embodiment, since the connecting member 328 electrically connects the camera housing 320 and the ground portion within the camera housing 320, a region of the printed circuit board 310 for the connecting member 328 exposed to the outside of the camera housing 320 may not be required. For example, when a portion of the connecting member 328 is positioned outside the camera housing 320, a region of the printed circuit board 310 for soldering the portion of the connecting member 328 exposed to the outside of the camera housing 320 to the printed circuit board 310 may be required. Since the region of the printed circuit board 310 for the soldering is required, a size of the printed circuit board 310 may be increased. According to an embodiment, since the connecting member 328 extends inside the camera housing 320 and is positioned inside the housing 320, the camera housing 320 may be electrically connected to the ground portion without increasing the size of the printed circuit board 310. According to an embodiment, since the camera housing 320 is directly grounded to the ground region through the connecting member 328, the grounding performance of the camera housing 320 may be enhanced.

According to an embodiment, an electronic device (e.g., the electronic device 101 of FIG. 3) may comprise a printed circuit board (e.g., the printed circuit board 310 of FIG. 6), a camera (e.g., the camera 181 of FIG. 6), a camera housing (e.g., the camera housing 320 of FIG. 6), and a bracket (e.g., the bracket 330 of FIG. 6). The printed circuit board may include a ground portion. The camera may include a lens (e.g., the lens 210 of FIG. 6). The lens may face a first direction. The camera housing may include an opening (e.g., the opening 323 of FIG. 6). The opening may be formed to expose the lens to the outside of a first surface (e.g., first surface 321 of FIG. 6) of the camera housing facing the first direction. The camera housing may surround at least a portion of the camera. The bracket may include a third surface (e.g., the third surface 331 of FIG. 6). The third surface may face away from a second surface (e.g., the second surface 322 of FIG. 6) of the camera housing, which is perpendicular to the first surface. The bracket may be electrically connected to the ground portion. The bracket may at least partially surround the camera housing. The camera housing may further include a bridge (e.g., the bridge 324 of FIG. 6). The bridge may extend from the camera housing to the third surface of the bracket.

According to an embodiment, the bridge may extend from a portion of a periphery (e.g., the periphery 323a of FIG. 5A) of the opening to the third surface of the bracket. The bridge may include a bending portion (e.g., the bending portion 324a of FIG. 6). The bending portion may be bent from the portion toward a third direction opposite to a second direction toward the lens passing through the opening. According to an embodiment of the present disclosure, the camera housing may be electrically connected to a ground portion through a bridge. The bridge may be contacted with a bracket electrically connected to the ground portion. As the camera housing is electrically connected to the ground portion, the camera housing may be grounded. Since the camera housing surrounds at least a portion of the camera, it may be configured to shield electromagnetic waves reaching the camera from other electronic components and/or electromagnetic waves emitted from the camera. As the camera housing is grounded, electromagnetic interference between the camera and other electronic components (e.g., speaker, microphone, or antenna) within the electronic device may be reduced. According to an embodiment, the electronic device may reduce malfunctions and/or degradation of signal quality due to noise by reducing electromagnetic interference. The bridge for grounding the camera housing may fasten the camera housing to the bracket by supporting the camera housing with respect to the bracket. Since the bridge extends from a periphery of the opening within the first surface, the stress generated by supporting the camera housing may not be transferred to the camera inside the camera housing, but may transferred to the first surface. According to an embodiment, the stress applied to the camera within the camera housing may be reduced.

According to an embodiment, the camera housing may be electrically connected to the ground portion, through the bridge contacted with the third surface of the bracket, which is electrically connected to the ground portion. According to an embodiment of the present disclosure, the bridge may electrically connect the camera housing and the bracket by contacting the bracket. Since the bracket is electrically connected to the ground portion, the camera housing may be grounded through the bracket. According to an embodiment, the camera housing may be grounded through a structure of the camera housing without a separate connecting member (e.g., c-clip or conductive tape) for grounding the camera housing.

According to an embodiment, the bridge may extend to the third surface through a gap (e.g., the gap g of FIG. 6) between the second surface of the camera housing and the third surface of the bracket. According to an embodiment of the present disclosure, a gap may be formed between the camera housing and the camera. The bridge may support the camera housing relative to the bracket by extending through the gap. In the gap between the second surface and the third surface, the bridge may fix the camera housing within the bracket.

According to an embodiment, the bridge may include a first portion (e.g., the first portion 324-1 of FIG. 6) and a second portion (e.g., the second portion 324-2 of FIG. 6). The first portion may extend from the bending portion in the third direction. The second portion may extend from the first portion in a direction between the third direction and a fourth direction opposite to the first direction. The second portion may be contacted with the third surface.

According to an embodiment, at least a portion of the second portion may extend to a gap between the second surface and the third surface.

According to an embodiment, the camera may be coupled to the camera housing in the fourth direction. According to an embodiment of the present disclosure, the bridge may include a first portion extending from a periphery of the opening toward a periphery of the first surface and a second portion extending from the first portion to the third surface of the bracket. The first portion and the second portion may electrically connect the camera housing to the bracket while occupying a minimum space. The camera housing including the bending portion, the first portion, and the second portion may be coupled to the bracket in a fourth direction opposite the first direction.

According to an embodiment, the bridge may include a first portion (e.g., the first portion 324-1 of FIG. 8A), a second portion (e.g., the second portion 324-2 of FIG. 8A), and a third portion (e.g., the third portion 324-3 of FIG. 8A). The first portion may extend from the bending portion in the third direction. The second portion may extend, from the first portion, in a direction between the third direction and a fourth direction opposite to the first direction, to a gap between the second surface and the third surface. The third portion may extend from the second portion in a direction between the first direction and the third direction. The third portion may be contacted with the third surface.

According to an embodiment, the camera may be coupled to the camera housing in the first direction. According to an embodiment of the present disclosure, the bridge may include a bending portion, a first portion, a second portion, and a third portion. The camera housing including the bridge of the above structure may be coupled to the bracket in the first direction. According to an embodiment, the structure of the bridge may be determined based on a coupling direction of the camera housing and the bracket. According to an embodiment, the camera housing may be electrically connected to the bracket by including a bridge of an appropriate structure according to the coupling direction of the camera housing and the bracket.

According to an embodiment, the bracket may include a groove (e.g., the groove 332 of FIG. 6). The groove may be formed within the third surface. The bridge may include an inserting portion (e.g., the inserting portion 324b of FIG. 6). The inserting portion may be inserted into the groove. The inserting portion may fix the camera housing to the bracket. The camera housing may be fixed within the bracket through the inserting portion inserted into the groove. The inserting portion may prevent the camera housing from being separated from the bracket. The contact area between the bridge and the bracket may be increased through the inserting portion and the groove that are contacted with each other. As the contact area between the bridge and the bracket is increased, an electrical connection between the camera housing and the bracket may be improved, so the grounding effect of the camera housing may be improved.

According to an embodiment, the bridge may elastically support the camera housing with respect to the bracket. According to an embodiment of the present disclosure, the bridge may have elasticity. For example, the bridge may include an elastic material. The bridge may be inserted into the gap between the second surface and the third surface in a compressed state. By the elasticity of the bridge, the camera housing may be coupled within the bracket. The bridge may connect the camera housing and the bracket without a separate coupling member, by coupling the camera housing to the bracket. Since the bridge has elasticity, the stress applied to the camera housing may be reduced. The bridge having elasticity may reduce damage to the camera within the camera housing by reducing the stress.

According to an embodiment, the camera housing may include a plurality of bridges (e.g., the plurality of bridges 325a, 325b, 325c, and 325d of FIG. 5B). The plurality of bridges may be formed along the periphery of the opening. The plurality of bridges may be symmetrical to each other. According to an embodiment of the present disclosure, the plurality of bridges may be disposed symmetrically to each other. The plurality of bridges may increase the grounding area for grounding the camera housing. Through the plurality of bridges, the grounding effect of the camera housing may be improved.

According to an embodiment, the bridge may penetrate the bracket. The bridge may extend to the ground portion. According to an embodiment of the present disclosure, the bridge may be directly connected to the ground portion. As the bridge is directly connected to the ground portion, the grounding effect of the camera housing may be improved.

According to an embodiment, the electronic device may further include a support (e.g., the support 344 of FIG. 11B). The support may support a portion of components of the electronic device. The support may include a grounding region. The bridge may penetrate the bracket. The bridge may extend to the grounding region of the support. According to an embodiment of the present disclosure, the bridge may be directly connected to the grounding region of the support. As the bridge is directly connected to the grounding region, the grounding effect of the camera housing may be improved.

According to an embodiment, the bracket may include a through hole (e.g., the through hole 333 of FIG. 11A) and a protruding portion (e.g., the protruding portion 334 of FIG. 11A). The bridge may pass the through hole. The protruding portion may be contacted with the through hole. A screw (e.g., the screw 350 of FIG. 11A) may be inserted into the protruding portion. The screw may penetrate the protruding portion and the bridge. The screw may be inserted into the grounding region to electrically connect the bridge to the grounding region. According to an embodiment of the present disclosure, when the bridge penetrates the bracket, the bracket may include a through hole for the bridge. The bridge may be exposed to the outside of the bracket, through the through hole. The bridge exposed to the outside of the bracket may be connected to the grounding region of the support through the screw. The bracket may be fixed to the support through the screw penetrating the protruding portion.

According to an embodiment, the first surface may include a cut portion (e.g., the cut portion 321b of FIG. 5A) cut out from a portion of the periphery of the opening toward the periphery of the first surface, such that the bending portion is disposed outside the opening. According to an embodiment of the present disclosure, since the bending portion extends from a portion of the periphery of the opening, it may protrude into the opening. When the bending portion protrudes into the opening, interference may occur with a lens of the camera. In order to eliminate the interference, the first surface may include a portion cut along a portion where the bridge is formed, toward the periphery of the first surface. When the bending portion is bent, the cut portion may be bent toward the periphery of the first surface. According to an embodiment, interference between the bending portion and the lens may be reduced because the bending portion does not protrude into the opening.

According to an embodiment, a camera module (e.g., the camera module 180 of FIG. 3) may include a camera (e.g., the camera 181 of FIG. 6), a camera housing (e.g., the camera housing 320 of FIG. 6), and a bracket (e.g., the bracket 330 of FIG. 6). The camera may include a lens (e.g., the lens 210 of FIG. 6). The lens may face a first direction. The camera housing may include an opening (e.g., the opening 323 of FIG. 6). The opening may be formed for the lens exposed toward the outside within a first surface (e.g., the first surface 321 of FIG. 6) facing the first direction. The camera housing may surround at least a portion of the camera. The bracket may include a third surface (e.g., the third surface 331 of FIG. 6). The third surface may be faced away from a second surface (e.g., the second surface 322 of FIG. 6) of the camera housing that is perpendicular to the first surface. The bracket may be electrically connected to the ground portion of the printed circuit board. The bracket may at least partially surround the camera housing. The camera housing may further include a bridge (e.g., the bridge 324 of FIG. 6). The bridge may extend from a portion of the periphery of the opening to the third surface of the bracket. The bridge may include a bending portion (e.g., the bending portion 324a of FIG. 6). The bending portion may be bent from the portion in a third direction opposite to a second direction toward the lens passing through the opening. According to an embodiment of the present disclosure, the camera housing may be electrically connected to the ground portion through a bridge. The bridge may be contacted with a bracket electrically connected to the ground portion. As the camera housing is electrically connected to the ground portion, the camera housing may be grounded. Since the camera housing surrounds at least a portion of the camera, it may be configured to shield electromagnetic waves reaching the camera from other electronic components and/or electromagnetic waves emitted from the camera. The bridge for grounding the camera housing may fasten the camera housing to the bracket by supporting the camera housing with respect to the bracket. Since the bridge extends from the periphery of the opening in the first surface, the stress generated by supporting the camera housing may not be transferred to the camera inside the camera housing but may be transferred to the first surface. According to an embodiment, the stress applied to the camera inside the camera housing may be reduced.

According to an embodiment, the camera housing may be electrically connected to the ground portion, through the bridge contacted with the third surface of the bracket electrically connected to the ground portion. According to an embodiment of the present disclosure, the bridge may electrically connect the camera housing and the bracket by contacting the bracket. Since the bracket is electrically connected to the ground portion, the camera housing may be grounded through the bracket. According to an embodiment, the camera housing may be grounded through the structure of the camera housing without a separate connecting member (e.g., c-clip or conductive tape) for grounding the camera housing.

According to an embodiment, the bridge may extend to the third surface through a gap (e.g., the gap g of FIG. 6) between the second surface of the camera housing and the third surface of the bracket. According to an embodiment of the present disclosure, a gap may be formed between the camera housing and the camera. The bridge may support the camera housing relative to the bracket by extending through the gap. In the gap between the second surface and the third surface, the bridge may fix the camera housing within the bracket.

According to an embodiment, the bridge may include a first portion (e.g., the first portion 324-1 of FIG. 6) and a second portion (e.g., the second portion 324-2 of FIG. 6). The first portion may extend from the bending portion in the third direction. The second portion may extend from the first portion in a direction between the third direction and a fourth direction opposite to the first direction. The second portion may be contacted with the third surface. According to an embodiment of the present disclosure, the bridge may include a first portion extending from the periphery of the opening toward the periphery of the first surface, and a second portion extending from the first portion to the third surface of the bracket. The first portion and the second portion may electrically connect the camera housing to the bracket while occupying a minimum space. The camera housing including a bending portion, a first portion, and a second portion may be coupled to the bracket in a fourth direction opposite to the first direction.

According to an embodiment, the bridge may include a first portion (e.g., the first portion 324-1 of FIG. 8A), a second portion (e.g., the second portion 324-2 of FIG. 8A), and a third portion (e.g., the third portion 324-3 of FIG. 8A). The first portion may extend from the bending portion in the third direction. The second portion may extend, from the first portion, in a direction between the third direction and a fourth direction opposite to the first direction, to a gap between the second surface and the third surface. The third portion may extend from the second portion in a direction between the first direction and the third direction. The third portion may be contacted with the third surface. According to an embodiment of the present disclosure, the bridge may include a bending portion, a first portion, a second portion, and a third portion. The camera housing including the bridge of the above structure may be coupled to the bracket in the first direction. According to an embodiment, the structure of the bridge may be determined based on the coupling direction of the camera housing and the bracket. According to an embodiment, the camera housing may be electrically connected to the bracket by including a bridge of an appropriate structure according to the coupling direction of the camera housing and the bracket.

According to an embodiment, the bracket may include a groove (e.g., the groove 332 of FIG. 6). The groove may be formed within the third surface. The bridge may include an inserting portion (e.g., the inserting portion 324b of FIG. 6). The inserting portion may be inserted into the groove. The inserting portion may fix the camera housing to the bracket. The camera housing may be fixed within the bracket through the inserting portion inserted into the groove. The inserting portion may prevent the camera housing from being separated from the bracket. The contact area between the bridge and the bracket may be increased through the inserting portion and the groove that are contacted with each other. As the contact area between the bridge and the bracket is increased, the electrical connection between the camera housing and the bracket may be improved, so the grounding effect of the camera housing may be improved.

According to an embodiment, an electronic device (e.g., the electronic device 101 of FIG. 3) may include a printed circuit board (e.g., the printed circuit board 310 of FIG. 10A), a camera (e.g., the camera 181 of FIG. 10A), a camera housing (e.g., the camera housing 320 of FIG. 10A), and a bracket (e.g., the bracket 330 of FIG. 10A). The printed circuit board may include a ground portion. The camera may include a lens (e.g., the lens 210 of FIG. 10A) facing a first direction. The camera housing may include an opening (e.g., the opening 323 of FIG. 10A) for the lens exposed to the outside within a first surface (e.g., the first surface 321 of FIG. 10A) facing the first direction. The camera housing may surround at least a portion of the camera. The bracket may include a third surface (e.g., the third surface 331 of FIG. 10A). The third surface may be faced away from a second surface (e.g., the second surface 322 of FIG. 10A) of the camera housing, which is perpendicular to the first surface. The bracket may be electrically connected to the ground portion. The bracket may at least partially surround the camera housing. The camera housing may further include a bridge (e.g., the bridge 324 of FIG. 10A). The bridge may extend, from a portion of another end portion (e.g., the other end portion 322b of FIG. 10A) of the second surface opposite to an end portion (e.g., the end portion 322a of FIG. 10A) of the second surface connected to the first surface, to the third surface of the bracket. The bridge may include a first portion (e.g., the first portion 324-1 of FIG. 10A). The first portion may extend in a direction between the first direction and a third direction opposite to a second direction toward the lens passing through the opening from the first portion.

According to an embodiment, the bridge may further include a second portion (e.g., the second portion 324-2 of FIG. 10B). The second portion may extend, from the first portion, in a direction between the third direction and a fourth direction opposite to the first direction. The second portion may be contacted with the third surface.

According to an embodiment, an electronic device may comprise a printed circuit board, a camera, a camera housing, an injection portion (e.g., the injection portion 326 of FIG. 13B), and a connecting member (e.g., the connecting member 328 of FIG. 13B). The printed circuit board may include a ground portion. The camera may include a lens. The camera may be disposed on the printed circuit board. The camera housing may surround at least a portion of the camera. The injection portion may be disposed inside the camera housing. The injection portion may surround at least a portion of the camera. The connecting member may extend from a portion of the inner surface of the camera housing exposed through a groove (e.g., the groove 327 of FIG. 13B) of the injection portion, to the ground portion. According to an embodiment of the present disclosure, the camera housing and the ground portion may be electrically connected through the connecting member. The connecting member may be contacted with the inner surface of the camera housing exposed through the groove. Since the camera housing may be directly grounded, the ground performance of the camera module may be enhanced. As the ground performance of the camera module is enhanced, electromagnetic interference (EMI) and/or electromagnetic susceptibility (EMS) may be improved.

According to an embodiment, the connecting member may be overlapped with the camera housing, by extending from the portion of the inner surface to the ground portion within the camera housing. According to an embodiment of the present disclosure, the connecting member may be positioned only inside the camera housing. Since the connecting member is not exposed to the outside of the camera housing, an increase in the size of the printed circuit board may not be required.

According to an embodiment, the groove may include a plurality of grooves spaced apart from each other. The connecting member may include a plurality of portions of the inner surface of the camera housing exposed through the plurality of grooves and a plurality of connecting members contacted with the ground portion. According to an embodiment of the present disclosure, numbers and positions of the groove and the connecting member may vary.

According to an embodiment, the injection portion may include an opening for the camera.

According to an embodiment, the groove may be formed by cutting a portion of the injection portion toward the inner surface of the camera housing, from the periphery of the opening. According to an embodiment of the present disclosure, as a portion of the injection portion surrounding the inner surface of the camera housing is cut, the inner surface of the camera housing may be exposed. The connecting member may electrically connect the camera housing to the ground portion by contacting the exposed inner surface of the camera housing.

The problems to be solved by the embodiments disclosed in this document are not limited to those described above, and various modifications may be made without departing from the spirit and scope disclosed in this document.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a printed circuit board (PCB) including a ground portion;
a camera including a lens facing a first direction;
a camera housing, surrounding at least portion of the camera, including an opening for exposing the lens to an outside of a first surface of the camera housing facing the first direction; and
a bracket, including a third surface facing away from a second surface of the camera housing, which is perpendicular to the first surface, electrically connected to the ground portion, and at least partially surrounding the camera housing,
wherein the camera housing includes a bridge extending from the camera housing to the third surface of the bracket.

2. The electronic device of claim 1,
wherein the bridge extends from a portion of a periphery of the opening to the third surface of the bracket, and
wherein the bridge includes a bending portion that bends from the portion of the periphery of the opening in a third direction, the third direction opposite to a second direction toward the lens passing through the opening.

3. The electronic device of any one of claims 1 and 2,
wherein the bridge extends to the third surface via a gap between the second surface of the camera housing and the third surface of the bracket.

4. The electronic device of any one of claims 1 to 3,
wherein the bridge includes:
a first portion extending from the bending portion in the third direction, and
a second portion, extending from the first portion in a direction between the third direction and a fourth direction opposite to the first direction, contacted with the third surface.

5. The electronic device of any one of claims 1 to 4,
wherein at least portion of the second portion extends to the gap between the second surface and the third surface.

6. The electronic device of any one of claims 1 to 5,
wherein the bridge includes:
a first portion extends from the bending portion in the third direction, and
a second portion, extending from the first portion, in a direction between the third direction and a fourth direction opposite to the first direction, to a gap between the second surface of the camera housing and the third surface of the bracket, and
a third portion, extending from the second portion in a direction between the first direction and the third direction, contacted with the third surface.

7. The electronic device of any one of claims 1 to 6,
wherein the bracket includes a groove formed in the third surface, and
wherein the bridge includes an inserting portion, inserted into the groove, fixing the camera housing to the bracket.

8. The electronic device of any one of claims 1 to 7,
wherein the bridge elastically supports the camera housing with respect to the bracket.

9. The electronic device of any one of claims 1 to 8,
wherein the camera housing includes a plurality of bridges formed along the periphery of the opening, and
wherein the plurality of bridges are symmetrical to each other.

10. The electronic device of any one of claims 1 to 9,
wherein the bridge penetrates the bracket and extends to the ground portion.

11. The electronic device of any one of claims 1 to 10, further comprising a support, supports a portion of components of the electronic device, including a ground region,
wherein the bridge penetrates the bracket and extends to the ground region of the support.

12. The electronic device of any one of claims 1 to 11,
wherein the bracket includes:
a through hole through which the bridge passes, and
a protruding portion, contacted with the through hole, into which a screw is inserted, and
wherein the screw electrically connects the bridge to the ground portion by penetrating the protruding portion and the bridge and being inserted into the ground portion.

13. The electronic device of any one of claims 1 to 12,
wherein the first surface includes
a cut portion cut out from a portion of the periphery of the opening toward the periphery of the first surface, such that the bending portion is disposed outside the opening.

14. The electronic device of any one of claims 1 to 13,
wherein the bridge extends from a portion of an end portion of the second surface, which is opposite to an end portion of the second surface connected to the first surface, to the third surface of the bracket, and
wherein the bridge includes a first portion extending from the portion in a direction between the first direction and a third direction, the third direction opposite to a second direction toward the lens passing through the opening.

15. The electronic device of any one of claims 1 to 14,
wherein the bridge includes a second portion, contacted with the third surface, extending from the first portion in a direction between the third direction and a fourth direction, the fourth direction opposite to the first direction.
